# FASCICULE DE BREVET EUROPEEN

(11) **EP 0 328 591 B1**
(45) Date de publication et mention de la délivrance du brevet: **30.06.1993**
(21) Numéro de dépôt: 88907015.7
(22) Date de dépôt: 29.07.1988
(51) Int. Cl.: G02B 26/04

(54) **INTERRUPTEUR OPTOMAGNETIQUE**
MAGNETO-OPTISCHER SCHALTER
OPTOMAGNETIC SWITCH

(30) Priorité: 31.07.1987 FR 8710880
(43) Date de publication de la demande: 23.08.1989
(73) Titulaire: SOULOUMIAC, Alain, F-93100 Montreuil (FR)
(72) Inventeur: FARGETTE, Alain, F-93150 Le Blanc-Mesnil (FR); MARLAND, André, F-92270 Bois-Colombes (FR); THOMAS, Fabrice, F-75012 Paris (FR)
(74) Mandataire: Viard, Jean
(86) Numéro de dépôt international: FR8800394
(87) Numéro de publication internationale: WO8901173

(56) Documents cités:
- EP-A- 0 115 126
- US-A- 3 787 837
- US-A- 4 060 313
- US-A- 4 376 566

## Description

La présente invention concerne un interrupteur qui a pour fonction d'interrompre un trajet de lumière sous l'effet d'une commande magnétique.

L'électricité et l'électronique se sont généralisées. Avec elles, les interrupteurs et les claviers se sont multipliés. Sensibles à l'usure, aux rebonds, à l'eau, à l'électricité statique, déflagrants, ils comportent également des défauts opérationnels. L'interrupteur optomagnétique permet de les éviter. Enfermé dans un boîtier étanche, il est insensible aux impuretés de l'air et aux liquides.

Un premier moyen de réaliser ce type d'interrupteur est décrit dans FR-A-2 595 022. Il consiste à placer une bille métallique dans un trou cylindrique traversant en son milieu le trajet de lumière. Lorsqu'on approche un aimant de la bille, celle-ci se lève et vient interrompre ou libérer le trajet de lumière. Mais ce système présente le défaut d'être sensible aux chocs et aux vibrations.

Un second moyen, éliminant cette sensibilité aux vibrations, est proposé dans la demande de brevet précitée. Il consiste à prendre une lame métallique assez fine pour constituer un ressort sensible à une attraction magnétique et à plier une de ses extrémités, pour former un volet obturant le trajet de lumière, l'autre extrémité étant fixée sur la base de l'interrupteur.

Tel qu'il est décrit, cet interrupteur ne fonctionne pas de manière fiable. Dans un clavier bureautique comportant une centaine de touches, il s'est avéré quasiment impossible de faire en sorte que toutes les touches soient en état opérationnel simultanément.

A l'usage, il en comporte certaines limites qui introduisent des frottements dans le fonctionnement de l'interrupteur et des risques de blocage. Tel que décrit, l'obturateur tend à décrire un arc de cercle dans son logement. Ceci impose de prévoir, dans l'interrupteur, une grande fente d'obturation, ce qui est gênant lorsqu'on utilise des fibres optiques comme trajet de lumière, étant donné que plus le fente est grande, plus les pertes de lumières sont importantes. Si l'on réduit cette fente, on constate que l'obturateur tend à frotter les bords d'une des fibres et à se bloquer sur la base de l'interrupteur.

Le document EP-A-0 115 126 (Frequency Control Products INC) décrit un interrupteur pour fibres optiques simples. Tel que représenté sur ses figures 5 et 6, cet interrupteur comporte une base traversée par un trajet de lumière, ainsi qu'une fente de guidage coupant le trajet. A côté de la fente de guidage, il existe un volume plus dégagé enfermant un arbre portant un disque pivotant. Une lame mince s'étend depuis le disque dans la fente, et selon la position angulaire du disque, la lame obture ou n'obture pas le trajet de lumière.

Un aimant, disposé sur l'autre côté du disque, est actionné par un second aimant mobile placé à l'extérieur de la base. Un ressort ramène la lame vers une position de repos, et une butée limite le déplacement dû au ressort. Cette structure comportant au moins cinq pièces mobiles à l'intérieur de la base, est complexe et ne convient pas pour une application qui a besoin d'une grande quantité d'interrupteurs bon marché, tel qu'un clavier bureautique se compose, d'habitude, d'une centaine de touches. En outre, cet interrupteur est encombrant. Par contre, l'emploi d'un aimant intérieur et d'un aimant extérieur assure la transmission d'une force adéquate pour un fonctionnement fiable.

US-A-4 376 566 décrit un interrupteur optique à commande électromagnétique ce qui conduit à un encombrement notable. Un ressort à lame ramène l'obturateur dans sa position de repos. Mais l'obturateur n'est pas constitué par la lame et ne se déplace pas dans le plan de symétrie longitudinale de la lame.

US-A-3 787 837 se rapporte à un clavier modulaire à fibres optiques à fonctionnement mécanique, l'enfoncement d'une touche provoquant la compression d'un ressort et un mouvement de l'obturateur. Mais une touche du clavier doit être en contact avec le ressort ce qui pose des problèmes d'étanchéité et la fente dans laquelle se déplace l'obturateur doit permettre un débattement de celui-ci.

L'objectif de la présente invention est de proposer un interrupteur optique à commande magnétique, réduisant les coûts, l'encombrement et le nombre de pièces mobiles, tout en assurant un fonctionnement mécanique et optique fiable.

L'objet de la présente invention est un interrupteur optique à commande magnétique comprenant une base traversée par un trajet de lumière, matérialisé par un conduit optique, une fente de guidage coupant ledit trajet, un obturateur mobile déplaçable au moins partiellement dans ladite fente de guidage entre une position où il laisse passer la lumière sur ledit trajet et une position où il interrompt ce passage, et un ressort de rappel relié à l'obturateur, caractérisé en ce que ledit obturateur et ledit ressort constituent des parties d'une lame métallique allongée déformable dont l'extrémité arrière est fixée sur ladite base et dont l'extrémité avant constitue une tête d'attraction magnétique, ledit ressort de rappel étant constitué par la partie de ladite lame située entre ces deux extrémités, et l'obturateur étant constitué par une partie de l'extrémité avant parallèle à la direction longitudinale de la lame, ledit obturateur se déplaçant dans son plan, ce plan étant perpendiculaire à ladite lame et à l'axe du mouvement de rotation imposé par ledit ressort à ladite extrémité avant.

Il n'est donc pas indispensable d'intégrer une pièce aimantée supplémentaire à l'intérieur de la base, dans la mesure où la surface sur laquelle est appliqué le champ magnétique est sufffisamment grande. Une seule pièce mobile à l'intérieur de la base suffit au bon fonctionnement de l'interrupteur. De plus, le fait d'utiliser une assez grande surface pour l'attraction magnétique donne de la marge en ce qui concerne cette attraction, et il devient possible d'utiliser des matériaux réputés être peu magnétiques pour fabriquer la lame. On peut donc choisir de l'acier inoxydable ou un plastique chargé ou métallisé, par exemple, à cause de ses qualités de résistance à la corrosion et de résilience, tout en gardant de la place à l'intérieur de l'interrupteur pour la tête d'attraction magnétique dont la surface peut être de l'ordre de un quart de cm2, par exemple.

La présente invention a également pour objet un procédé de fabrication d'un interrupteur, caractérisé en ce qu'on forme ladite base avec ledit trajet de lumière matérialisé par un conduit optique, et qu'ensuite on coupe ladite base à travers ledit conduit optique utilisant un outil de coupe qui sert à la fois à former ladite fente de guidage, et à polir les extrémités dudit conduit optique pour optimiser le passage de lumière entre les deux tronçons de conduit optique séparés par l'outil.

On obtient ainsi un bilan optique favorable, du fait que les deux tronçons de conduit optique (par exemple une fibre optique) sont d'office bien alignés et sans décalage mutuel. Des pertes de l'ordre de 2dB sont aisément atteignables, même en se donnant des marges de sécurité importantes, entre les extrémités des tronçons (et donc d'augmenter les pertes de lumière), pour des questions de jeu d'assemblage et, éventuellement, pour augmenter la fiabilité et la durée de vie de l'interrupteur.

Plusieurs modes de réalisation de cet interrupteur optique sont décrits, à titre d'exemple, en faisant référence aux dessins annexés dans lesquels :
- la figure 1 est une vue éclatée en perspective de l'interrupteur ;
- les figures 2A et 2B sont des vues de côté en coupe de cet interrupteur, respectivement en position de repos et en position de travail ;
- les figures 3A et 3B sont des vues de côté en coupe d'une variante de cet interrupteur, respectivement en position de repos et en position de travail ;
- la figure 4 est une vue de face de la fente de guidage ;
- la figure 5 représente un autre mode de réalisation du ressort de l'interrupteur, en vue de dessus.

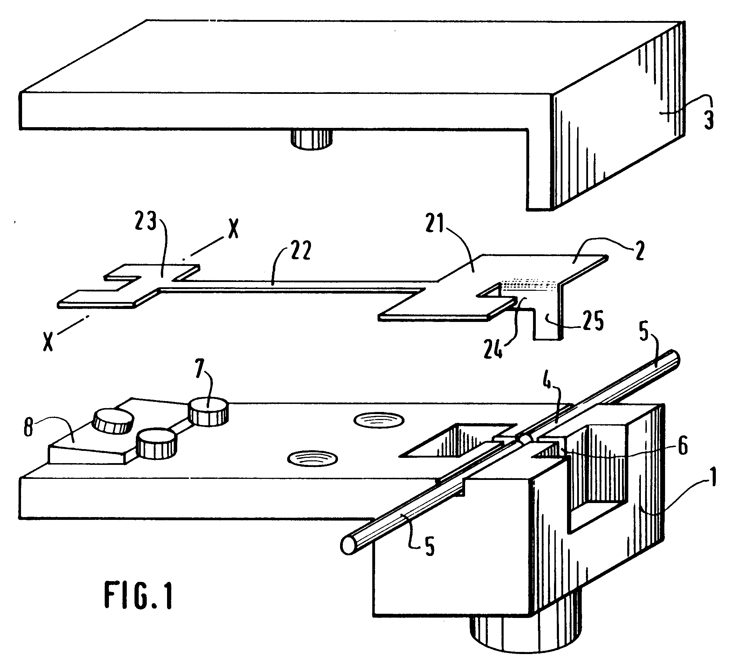

La figure 1 est une vue éclatée, en perspective, de l'interrupteur. La figure 1 représente les trois parties de l'interrupteur : une base 1, une lame-ressort 2 et un couvercle 3.

La base 1 présente une gorge 4 qui constitue un sillon du trajet de lumière. Ce sillon peut recevoir une fibre optique 5, comme dans l'exemple de la figure 1. Une fente d'obturation 6 est aménagée perpendiculairement au trajet de lumière, pour recevoir l'obturateur 24.

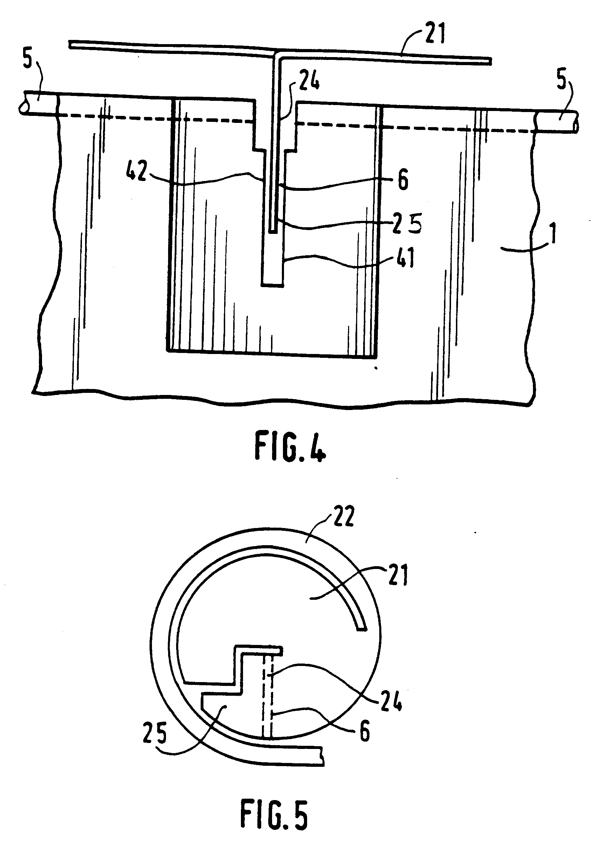

Cette fente est représentée en détail sur la figure 4. La fente d'obturation 6 comporte une partie 41, plus profonde que le sillon 4, de manière à permettre l'adjonction d'un guide mécanique 25 sur l'obturateur. Dans l'hypothèse d'une fibre, la fente d'obturation 6 doit être la plus mince possible, de manière à limiter les pertes de lumière dues à sa trajectoire atmosphérique.

A l'arrière de la base 1, se trouvent des plots 7 de fixation et de positionnement du ressort 22 de l'obturateur 24. Une pente 8 peut être prévue pour donner au ressort, en position de repos, une certaine force d'appui contre la base.

Le ressort 22, représenté sur la figure 1, est du type rectiligne. Il est formé dans une lame déformable qui comprend trois parties. La première constitue la tête d'attraction magnétique 21. Elle doit être suffisamment grande par rapport à l'ensemble pour permettre à la force magnétique de contrebalancer la force du ressort.

C'est un point fondamental pour le fonctionnement de l'obturateur. Cette tête d'attraction magnétique peut être formée du même matériau que le ressort 22. Certains types d'aciers inoxydables se sont montrés suffisamment sensibles à l'attraction magnétique. L'emploi de ce matériau peut être préféré pour ses qualités de durée de vie.

La seconde partie est une tige 22, qui constitue le ressort proprement dit, est aussi fine que possible. L'extrémité 23, qui peut être un segment de la lame 22, est la partie d'ancrage du ressort, et est conçue de manière à faciliter le positionnement de la pièce, par exemple en forme de "U".

Dans l'exemple décrit, l'obturateur 24 est un élément de la tête 21. Dans l'art antérieur, il est parallèle à l'axe X, autour duquel se produit le mouvement de rotation de la tête. Ceci entraîne un débattement de l'obturateur préjudiciable au bon fonctionnement de l'interrupteur.

Selon l'invention, l'obturateur est, au contraire, généralement perpendiculaire audit axe X, évitant ainsi tout débattement pouvant engendrer des blocages ou des frottements, et facilitant en outre, le positionnement sur la base de l'obturateur à la fabrication. En effet, dans la mesure où l'obturateur 24 est sensiblement plus large que le trajet optique qu'il interrompt, la distance séparant l'obturateur du point de fixation du ressort n'a plus besoin de tolérances très précises.

L'obturateur peut être prolongé d'un guide 25 qui empèche l'obturateur de venir frotter sur les faces polies des fibres, la fente de guidage 41 étant plus étroite que la fente d'obturation 42 (figure 4). L'obturateur 24 peut être formé du même matériau que la tête magnétique du ressort et résulter d'un simple pliage, après une découpe appropriée.

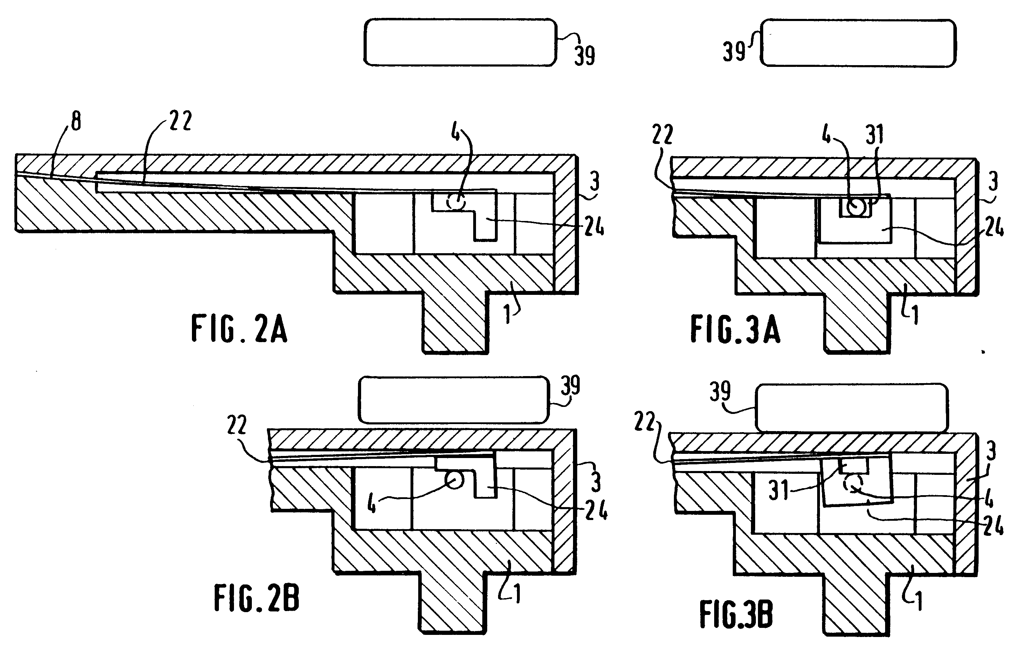

Une fenêtre 31 peut y être aménagée (figures 3A et 3B), de sorte que la lumière circule en position de repos, et qu'elle soit interrompue lorsque l'obturateur se lève sous l'effet de l'attraction magnétique.

Les figures 2A et 2B montrent les deux états de l'interrupteur : fermé (figure 2A) et ouvert (figure 2B), sous l'effet d'une attraction magnétique venant d'un aimant mobile 39.

Le ressort peut être légèrement cambré, ou la base 1 peut comprendre une section en pente surélevée 8 (figures 1 et 2A), pour recevoir l'extrémité 23 du ressort 22, afin d'augmenter la force de rappel de l'interrupteur en position de repos.

Ceci présente deux avantages : celui d'accroître l'insensibilité de l'interrupteur aux chocs et aux vibrations, et celui de tendre vers un système à deux états, l'obturateur passant plus franchement d'une position action à une position repos, sous l'effet de la commande magnétique.

D'autres formes de ressort et d'obturateur peuvent, bien entendu, être envisagées. Dans le but de diminuer l'encombrement de l'interrupteur, la partie 22 du ressort peut entourer la tête magnétique. Auquel cas, le ressort entourant la tête peut être circulaire, rectangulaire ou en spirale, selon l'exemple donné par la figure 5. On y retrouve les mêmes éléments que dans la figure 1 : le pli formant l'obturateur 24, le prolongement de guidage 25 et le bras de ressort 22. S'agissant d'un ressort d'un autre type, le boîtier doit être revu en conséquence. La figure 5 ne montre qu'un bras de ressort 22 pour un obturateur. Il serait toutefois possible d'en prévoir deux, ou même davantage, en s'inspirant des procédés utilisés dans les hauts-parleurs par exemple.

Le couvercle du boîtier 3 ayant un rôle de butée, conditionne la course de l'obturateur. Il peut être conçu suffisamment étanche pour être noyé dans une masse durcissable, afin de protéger les pièces optiques.

Pour fabriquer des interrupteurs à fibres, il apparaît préférable, quel que soit le type de boîtier, de couper la fibre à l'intérieur de l'interrupteur. Ceci permet de minimiser les pertes de lumière, les deux morceaux de fibres étant nécessairement positionnés face à face, du fait qu'on les a sectionnés sur place.

La base de l'interrupteur peut contenir une fente de guidage pour l'obturateur et un sillon de maintien de la fibre optique qui le traverse. La fibre est placée dans le sillon de maintien et elle est coupée en suivant la fente de guidage. La fente de guidage peut être légèrement élargie dans sa partie haute par l'outil de coupe, pour créer la fente d'obturation plus large que la fente de guidage proprement dite, évitant ainsi les frottements néfastes qui ont été décrits plus haut. Alternativement, la base ne comporte pas de fente de guidage préalable, celle-ci étant réalisée simultanément avec le sectionnement de la fibre ou autre conduit optique matériel.

La description qui précède concerne des interrupteurs simples, à un seul trajet optique, matérialisé par une fibre optique et à une seule lame mobile qui n'interagit avec la lumière qu'en tant qu'obturateur. Ceci convient bien à la compréhension de l'invention, et des interrupteurs tels que décrits sont efficaces dans les montages tels que des claviers bureautique. D'autres structures et fonctions, plus complexes, sont possibles.

Une seule lame peut interagir avec deux trajets de lumière ou davantage. Moyennant une fenêtre bien placée dans la lame, un trajet de lumière peut être interrompu pendant que l'autre est passant, et réciproquement.

Les trajets de lumière peuvent être des tubes vides (ou remplis d'air), ou ils peuvent être matérialisés en diverses formes de conduits optiques autres que les fibres optiques. Par exemple, la base peut être fabriquée dans une plaque optique dans laquelle des conduits optiques sont formés en dopant la plaque pour modifier localement son indice de réfraction.

Une seule plaque peut constituer la base de plusieurs interrupteurs, et même de tous les interrupteurs d'un clavier bureautique.

Une seule lame obturateur peut interagir avec des trajets optiques dans une configuration en T. Si l'interrupteur est réfléchissant, et si il est bien positionné (à environ 45° par rapport à chaque branche du T), l'obturateur peut fonctionner en tant que commutateur. C'est-à-dire que la lumière venant depuis la gauche (par exemple) continue, tout droit vers la droite, ou est déviée vers le bas, selon la position de l'obturateur. Un tel montage peut s'avérer très utile dans une application autre que le clavier bureautique, mais ayant besoin de nombreux interrupteurs : la commutation de signaux de télécommunications.

Il est possible de combiner les fonctions d'interrupteur proprement dit et le connecteur. Par exemple, une base d'interrupteur peut avoir deux connecteurs pour recevoir chacun l'extrémité d'un tronçon de fibres optiques, et donc assurer à la fois la connexion mécanique des tronçons, et le passage ou l'interruption, à volonté, de la lumière.

Un interrupteur optique fiable et bon marché, trouve des applications dans la commande des circuits électriques à partir des endroits dangereux, non seulement dans l'industrie, mais aussi à la maison, dans les salles de bains par exemple.

## Revendications

1. Interrupteur optique à commande magnétique comprenant une base (1) traversée par un trajet de lumière (4), matérialisé par un conduit optique (5), une fente de guidage (6) coupant ledit trajet, un obturateur mobile (24) déplaçable au moins partiellement dans ladite fente de guidage entre une position où il laisse passer la lumière sur ledit trajet et une position où il interrompt ce passage, et un ressort de rappel (22) relié à l'obturateur, caractérisé en ce que ledit obturateur et ledit ressort constituent des parties d'une lame métallique allongée déformable dont l'extrémité arrière (23) est fixée sur ladite base et dont l'extrémité avant (21) constitue une tête d'attraction magnétique, ledit ressort de rappel (22) étant constitué par la partie de ladite lame située entre ces deux extrémités, et l'obturateur (24) étant constitué par une partie de l'extrémité avant (21) parallèle à la direction longitudinale de la lame, ledit obturateur se déplaçant dans son plan, ce plan étant perpendiculaire à ladite lame et à l'axe du mouvement de rotation (X) imposé par ledit ressort à ladite extrémité avant.

2. Interrupteur selon la revendication 1, caractérisé en ce que l'obturateur (24) porte dans son plan un élément constituant un prolongement de guidage (25) demeurant engagé dans ladite fente de guidage (6) lorsque l'obturateur (24) arrive en fin de course.

3. Interrupteur selon l'une des revendications 1 ou 2, caractérisé en ce que ledit ressort (22) est en forme d'un bras rectiligne de largeur inférieure à celle des extrémités arrière (23) et avant (21).

4. Interrupteur selon l'une des revendications 1 ou 2, caractérisé en ce que ledit ressort est en forme d'au moins un bras qui entoure au moins partiellement la tête d'attraction magnétique.

5. Interrupteur selon l'une des revendications précédentes, caractérisé en ce que ledit ressort est précontraint, de manière à exercer, en position de repos, une certaine force d'appui contre ladite base.

6. Interrupteur selon l'une des revendications précédentes, caractérisé en ce que le matériau servant à la fabrication du ressort (22) est de l'acier inoxydable.

7. Interrupteur selon l'une des revendications précédentes, caractérisé en ce qu'une fenêtre (31) est aménagée dans ledit obturateur (24) pour permettre le passage de la lumière dans une desdites positions.

8. Procédé de fabrication d'un interrupteur, selon l'une des revendications précédentes, caractérisé en ce qu'on forme dans la base (1) un trajet de lumière (4), matérialisé par un conduit optique (5), et qu'ensuite on coupe ladite base à travers ledit conduit optique en utilisant un outil de coupe qui sert à la fois à former ladite fente de guidage, et à couper le conduit optique (5).

## Claims

1. Magnetically controled optical switch comprising a base having a light path materialized by an optical duct (5) passing theretrough a guide slot (6) intersecting said path, a moving shutter (24) displaceable at least partially inside said guide slot between a position where it allows light to pass along said path and a position where it interrupts said passage and a return spring (22) for the shutter characterized in that said shutter and said spring constitute portions of an elongated deformable blade the rear end of which being fixed to the base, the shutter (24) being constituted by a front end portion (21) extending parallely to the longitudinal direction of the blade, said shutter moving in its plane, said plane being perpendicular to the said lame and to the (X) axis of the rotational movement impulsed by said spring to said front end.

2. Switch according to claim 1 characterized in that the shutter (24) carries in its plane an element (25) constituting a guide extension which remains engaged in said guide slot (6) when the shutter (24) arrives at one end of its stroke.

3. Switch according to one of the claims 1 or 2 characterized in that the spring (22) is in shape of a generally linear arm with enlarged rear end (23) and front end (21).

4. Switch according to one of the claims 1 or 2 characterized in that said spring is in shape of at least one arm which at least partially surrounds the magnetic head.

5. Switch according to any one of the preceeding claims characterized in that said spring is prestressed so as to exert, in rest position, a degree of thrust against said base.

6. Switch according to one of the preceeding claims characterized in that the spring is made of stainless steel.

7. Switch according to one of the preceeding claims characterized in that a window (31) is provided in said shutter (24) in order to pass light in one of said positions.

8. A method of manufacturing a switch according to one of the preceeding claims characterized in that it comprises the steps of
- forming a light path (4), materialized by an optical duct (5) and
- subsequently cutting said base though said light duct using a cutting tool which is used simultaneously for forming said guide slot and for cutting the optical duct (5).

## Patentansprüche

1. Optischer Schalter zur magnetischen Betätigung mit einer von einem als optischer Leiter (5) ausgebildeten Lichtweg (4) durchsetzten Basis (1), einem den Lichtweg schneidenden Führungsschlitz (6), einen in diesem Führungsschlitz zwischen einer Stellung, in welcher das Licht auf dem Lichtweg durchgelassen ist, und einer Stellung, in welcher der Lichtweg unterbrochen ist, zumindest teilweise beweglich verschiebberen Verschluß (24) sowie einer mit dem Verschluß verbundenen Rückstellfeder (22),
dadurch gekennzeichnet,
daß der Verschluß (24) und die Feder (22) Teile eines verformbaren verlängerten Metallplättchens bilden, dessen hinteres Ende (23) auf der Basis (1) befestigt ist und dessen vorderes Ende (21) einen Kopf zum magnetischen Anziehen bildet, daß die Feder (22) aus dem zwischen den beiden Enden des Metallplättchens befindlichen Teil besteht und der Verschluß (24) durch einen zur Längsrichtung des Metallplättchens parallelen Teil von dessen vorderen Ende (21) gebildet ist, wobei der Verschluß (24) in seiner Ebene verschiebber ist und diese Ebene senkrecht zum Metallplättchen sowie zur Achse (X) der Drehbewegung verläuft, welche die Feder (22) dem vorderen Ende aufzwingt.

2. Schalter nach Anspruch 1, dadurch gekennzeichnet, daß der Verschlu8 (24) ein sich in seiner Ebene erstreckendes Element besitzt, welches eine Führungsverlängerung (25) bildet, die im Führungzschlitz (6) verbleibt, bis der Verschluß (6) sein Wegende erreicht.

3. Schalter nach Anspruch 1 oder 2, dadurch gekennzeichnet, daß die Feder (22) die Form eines geradlinigen Armes mit einer geringeren Breite als die des vorderen Endes (21) und hinteren Endes (23) aufweist.

4. Schalter nach Anspruch 1 oder 2, dadurch gekennzeichnet, daß die Feder (22) die Form wenigstens eines Armes aufweist, der zumindest teilweise den Kopf zum magnetischen Anziehen bildet.

5. Schalter nach einem der Ansprüche 1 bis 4, dadurch gekennzeichnet, daß die Feder (22) zur Ausübung einer Stützkraft in Ruhestellung gegen die Basis (1) vorgespannt ist.

6. Schalter nach einem der Ansprüche 1 bis 5, dadurch gekennzeichnet, daß es sich bei dem zur Herstellung der Feder (22) verwendeten Material um rostfreien Stahl handelt.

7. Schalter nach einem der Ansprüche 1 bis 6, dadurch gekennzeichnet, daß zum Durchlaß des Lichtes in eine dar besagten Stellungen ein Fenster (31) im Verschluß (24) vorgesehen ist.

8. Verfahren zur Herstellung eines Schalters nach einem der Ansprüche 1 bis 7, dadurch gekennzeichnet, daß in der Basis (1) ein durch einen optischen Leiter (5) ausgebildeter Lichtweg (4) geschaffen wird und daß dann die Basis (1) quer zum optischen Leiter (5) mittels eines Schneidewerkzeugs geschlitzt wird, wobei das Schneidewerkzeug sowohl zur Bildung des Führungsschlitzes (6) als auch zum Zerschneiden des optischen Leiters (5) dient.
